# FASCICULE DE BREVET EUROPEEN

(11) **EP 2 643 848 B1**
(45) Date de publication et mention de la délivrance du brevet: **24.07.2019**
(21) Numéro de dépôt: 11790940.8
(22) Date de dépôt: 24.11.2011
(51) Int. Cl.: H01L 29/775, H01L 29/06, H01L 29/40, H01L 29/423, H01L 29/417, H01L 21/336, H01L 21/8234, B82Y 40/00, B82Y 10/00, H01L 29/41

(54) **PROCEDE DE FABRICATION D'UN DISPOSITIF DE TRANSISTOR A EFFET DE CHAMP IMPLEMENTE SUR UN RESEAU DE NANOFILS VERTICAUX**
VERFAHREN ZUR HERSTELLUNG EINES FELDEFFEKTTRANSISTORS IN EINEM NETZWERK AUS VERTIKALEN NANODRÄHTEN
PROCESS FOR FABRICATING A FIELD-EFFECT TRANSISTOR DEVICE IMPLEMENTED ON A NETWORK OF VERTICAL NANOWIRES

(30) Priorité: 26.11.2010 FR 1059802
(43) Date de publication de la demande: 02.10.2013
(73) Titulaire: Centre National de la Recherche Scientifique (C.N.R.S.), 75016 Paris (FR)
(72) Inventeur: LARRIEU, Guilhem, F-31450 Baziege (FR)
(74) Mandataire: Lavoix
(86) Numéro de dépôt international: PCT/EP2011/070979
(87) Numéro de publication internationale: WO 2012/069606

(56) Documents cités:
- EP-A1- 1 804 286
- WO-A1-2004/040667
- WO-A1-2007/090814
- WO-A1-2008/118084
- CN-A- 101 399 207
- US-A1- 2010 117 138

## Description

La présente invention concerne un procédé de fabrication selon la revendication 1.

Le développement de la microélectronique est basé sur le dimensionnement des dispositifs de transistors qui outre un gain de place, permet d'améliorer les performances des dispositifs.

Néanmoins, le dimensionnement, c'est-à-dire la diminution des dimensions, en particulier la longueur de la grille d'un transistor, introduit des difficultés dans la réalisation desdits dispositifs, des coûts liés à la recherche et au développement et à la complexité technologique, mais aussi des limites associées à la physique même des dispositifs. Par exemple, la miniaturisation de la grille d'un transistor entraine une perte de commande du canal du transistor, appelée aussi effets canaux courts, qui dégrade les performances des dispositifs de transistors, par exemple en entraînant un courant de fuite élevé, un décalage de la tension de seuil..., et annihile les bénéfices inhérents à la miniaturisation.

Ainsi, de nouvelles architectures de grilles ont été introduites pour résoudre ce problème en améliorant le contrôle électrostatique du canal, par le biais de multi-grilles.

Il est connu que la configuration électrostatique optimale est générée par une grille dite « entourante » autour d'un petit élément de volume de semi-conducteur, par exemple une grille autour d'un nanofil. Le quasi parfait contrôle des effets canaux courts permet de démontrer en particulier des courants de fuites très faibles pour des longueurs de grille nanométriques.

Néanmoins, le courant de commande, c'est-à-dire le courant traversant le transistor à l'état passant, reste faible car limité par la petite section du nanofil. Il est donc primordial d'implémenter non pas un transistor sur un fil ou nanofil mais sur un réseau de nanofils afin de combiner l'excellent contrôle électrostatique avec un niveau de courant à l'état passant élevé.

L'intégration de transistors peut alors être réalisée sur des réseaux horizontaux ou verticaux. Les réseaux horizontaux sont difficiles à réaliser à grandes échelles car ils nécessitent l'empilement de nombreuses couches et l'intégration de dispositifs de transistors sur ces réseaux est encore plus complexe : difficultés pour définir une grille nanométrique sur les différentes couches, difficultés pour doper les zones source/drain....

L'intégration verticale permet de s'affranchir de ces problèmes. En effet, la réalisation de réseaux denses est plus aisée par approche descendante (gravure) tout comme par approche montante (croissance).

La réalisation de grille nanométrique ne nécessite pas d'étape de lithographie critique, par exemple de lithographie électronique, puisque la longueur de grille est simplement définie par l'épaisseur de la couche du matériau de grille déposée.

Les dispositifs de transistors à effet de champ implémentés sur un réseau de nanofils verticaux présentent néanmoins des difficultés, par exemple pour réaliser les contacts de source (ou drain) au bas (ou en haut) des transistors, de contrôle des capacités parasites de recouvrement grille/source-drain, pour réaliser des sources/drains auto-alignés sur la grille ou pour réaliser les couches de matériau isolant, également appelées espaceurs isolants entre la source ou le drain et la grille dont l'épaisseur et la planéité doivent être maitrisée afin d'assurer un bon contrôle des capacités parasites de recouvrement et de pouvoir réduire la longueur de grille.

Les documents US 2003/0 189 202 et US 7,446,025 décrivent des procédés de fabrication de dispositifs de transistors à effet de champ implémentés sur un réseau de nanofils verticaux.

Néanmoins, ces procédés sont relativement complexes. En effet, ils comprennent notamment une étape de formation d'une couche conductrice pour le contact du bas sur laquelle sont localisés des catalyseurs pour réaliser une croissance du réseau de nanofils. Or il est connu de l'homme du métier qu'il est extrêmement difficile de pouvoir à la fois faire croître verticalement avec une bonne reproductibilité des nanofils sur un métal ou siliciure (c'est-à-dire sans profiter des directions cristallines des substrats), et d'assurer une bonne tenue en température des matériaux métalliques.

En outre, US 2003/0 189 202 ne décrit pas de dispositif de transistor à effet de champ.

De plus, le dispositif de transistor à effet de champ décrit dans US 7,446,025 n'a pas de capacités optimisées car l'isolation entre la source (contact du bas) et la grille est constituée par l'isolant de grille, donc de faible épaisseur entraînant des capacités de couplage source/grille extrêmement élevées.

D'autres procédés de fabrication de dispositifs FET sur réseaux de nanofils verticaux sont décrits dans la littérature. Par exemple, M. Egard et al. dans l'article "Vertical InAs Nanowire Wrap Gate Transistors with ft > 7 GHz and fmax > 20 GHz", NanoLetters, 10(3), pp. 809-812, 2010, reprend une architecture présentée par C. Thelander et al. dans l'article intitulé "Development of a Vertical Wrap-Gated InAs FET", IEEE Trans. on Elec. Dev., 55(11), pp 3030-3036, Nov. 2008], V. Schmidt et al. dans l'article "Realization of a Silicon Nanowire Vertical Surround-Gate Field-Effect Transistor", Small, 2(1), pp 85-88, Jan 2006 ou par T. Tanaka et al. dans l'article intitulé "Vertical Surrounding Gate Transistors Using Single InAs Nanowires Grown on Si Substrates" Appl. Phys. Express 3, 025003, 2010 qui décrivent un procédé dans lequel la topologie de la grille est réalisée avec un effet de vague notable, supérieur à 50 nm, empêchant ainsi la miniaturisation de la longueur de grille tout en introduisant des capacités parasites entre une partie de la grille et le nanofil. Ce phénomène de vague est inhérent à la topologie de l'isolant d'espaceur qui au voisinage du nanofil induit une vague montante ou descendante suivant les modes de réalisations.

D'autres procédés de fabrication de dispositifs FET aux nanofils sont connus de WO 2007/090814, US 2011/012085, WO 2004/040667 et WO 2008/118084.

L'invention a donc pour but de simplifier de manière importante la fabrication de dispositifs de transistor implémenté sur un réseau de nanofils verticaux, de pouvoir diminuer ses dimensions à des régimes nanométriques et de minimiser les résistances d'accès des zones de source et de drain ainsi que les capacités de recouvrement.

L'invention a donc pour but de proposer des transistors ayant une faible résistance d'accès ainsi que de faibles capacités de recouvrement.

A cet effet, l'invention a pour objet un procédé de fabrication selon la revendication 1.

Suivant d'autres modes de réalisation, le procédé de fabrication est selon l'une quelconque des revendications 2 à 6.

L'invention et ses avantages seront mieux compris à la lecture de la description qui va suivre, donnée uniquement à titre d'exemple et faite en référence aux dessins annexés, sur lesquels :
- les figures 1 et 2 sont des représentations schématiques respectivement de profil et en coupe d'un transistor à effet de champ intégré sur un nanofil vertical,
- les figures 3 et 4 sont des représentations schématiques respectivement en coupe et de profil d'un dispositif électronique comprenant un transistor à effet de champ intégrés sur un réseau de nanofils verticaux,
- la figure 5 est une représentation schématique du procédé de fabrication selon le premier mode de réalisation de l'invention,
- la figure 6 est une représentation schématique d'une variante d'une étape du procédé de fabrication illustré sur la figure 5,
- la figure 7 est une représentation schématique du procédé de fabrication selon un autre mode de réalisation de l'invention,
- les figures 8 et 9 sont des ensembles de courbes représentant l'évolution du courant de drain respectivement en fonction de la tension de polarisation de l'électrode de grille et en fonction de la tension de polarisation de l'électrode de drain pour un dispositif de transistors du type pFET selon l'invention,
- la figure 10 est une représentation schématique du procédé de fabrication selon un exemple qui ne fait pas partie de l'invention telle que revendiquée, et
- les figures 11 et 12 sont des images d'exemples de réalisation de dispositifs obtenus grâce au procédé selon l'invention.

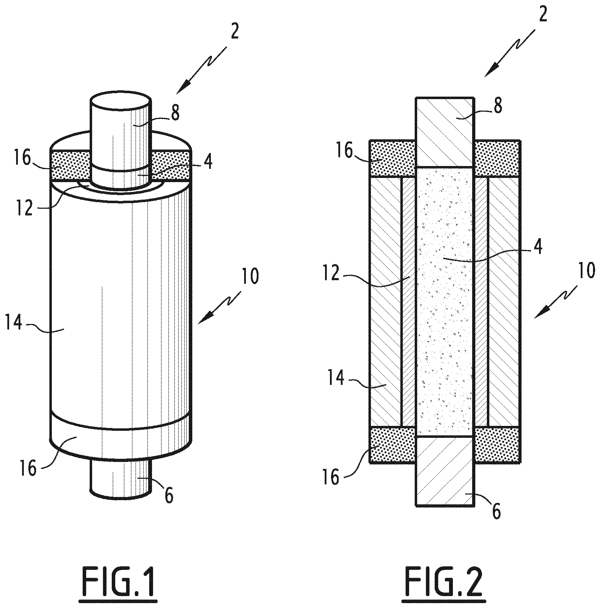

Les figures 1 et 2 présentent un transistor 2 à effet de champ (FET pour *« Field Effect Transistor* », en anglais) implémenté sur un nanofil vertical 4.

Le matériau composant le nanofil est du groupe IV (Si, Ge ...) ou de matériaux combinés tels que de groupes III-V (InAs, GaAs, InP, GaSb ...) selon la classification périodique des éléments et le nanofil est réalisé de façon connue par approche montante (croissance) ou descendante (gravure).

De façon connue, le transistor 2 est un dispositif semi-conducteur comportant trois électrodes actives : une source 6, un drain 8 et une grille 10. Un tel transistor permet de contrôler le passage d'un courant entre la source 6 et le drain 8 grâce à une électrode de contrôle : la grille 10.

De façon connue, la grille 10 est composée d'un empilement de type métal oxyde semi-conducteur (MOS) comportant une première couche 12 constituée d'un diélectrique dit de grille entourant le nanofil 4 et une seconde couche 14 constituée d'un conducteur dit de grille, de préférence un métal, entourant la première couche 12.

Le conducteur de grille constituant la seconde couche 14 est constitué de tout matériau conducteur comme un métal, un siliciure ou du polysilicium.

Suivant le matériau de nanofils utilisé, l'isolant ou diélectrique de grille de la première couche 12 est un matériau à haute constante diélectrique, par exemple HfO₂, ZrO₂, Al₂O₃, Gd₂O₃ ... (et tous leurs composés) déposé par dépôt de couche atomique (ALD pour « *atomic layer deposition* », en anglais) ou dépôt chimique en phase vapeur (CVD pour « *chemical vapor deposition* », en anglais) ou si le nanofil est en silicium, un oxyde, par exemple SiO₂, SiON, crut thermiquement ou un matériau à haute constante diélectrique.

La grille est de dimensions nanométriques, par exemple sa longueur est sensiblement comprise entre 0,1 nm et 30 nm et l'épaisseur du diélectrique est sensiblement comprise entre 0,1 nm et 10 nm.

Le contrôle électrostatique du canal composé par le nanofil est assuré par la grille entourante de dimension nanométrique.

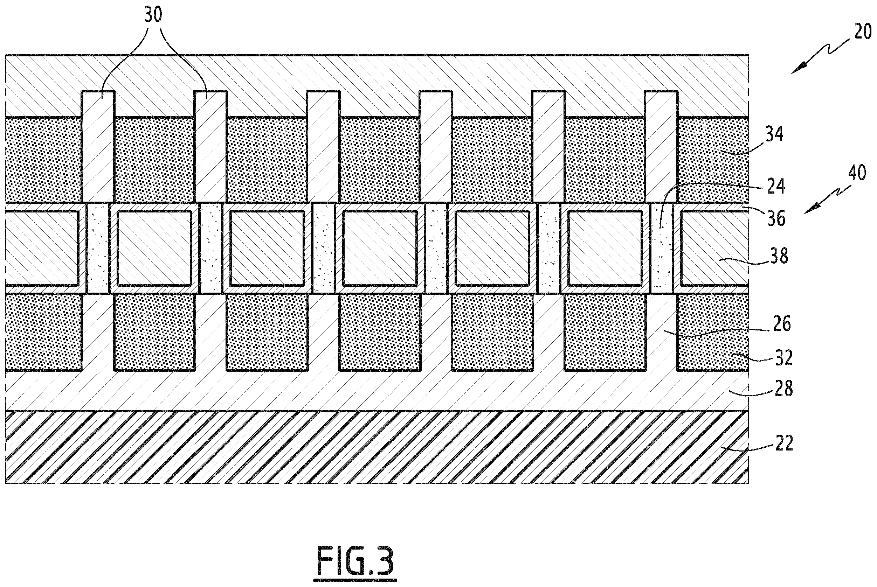

Sur la figure 3, un dispositif électronique 20 obtenu grâce à un procédé qui ne fait pas partie de l'invention telle que revendiquée, et comprend des transistors 2 à effet de champ implémentés/intégrés sur des nanofils verticaux à partir de transistors élémentaires tels que représentés sur les figures 1 et 2.

Le dispositif électronique 20 comporte un substrat 22, par exemple en silicium et un réseau de nanofils verticaux 24, les nanofils étant arrangés de façon régulière sur le substrat 22 et de préférence selon deux dimensions.

Chaque nanofil est en un matériau du groupe IV, tel que le silicium Si, Ge... ou des groupes III-V, par exemple InAs, GaAs... selon la classification périodique des éléments.

Chaque nanofil 24 est de préférence en silicium.

L'extrémité de chaque nanofil 24 en regard du substrat 22 est appelé pied des nanofils et comporte un contact dit « de bas » ou de source 26 d'un transistor tel que décrit précédemment. Tous les contacts de source 26 ont la même longueur et sont reliés par une couche 28 de matériau afin de former une extension pour un unique contact ou électrode de source pour le dispositif électronique 20, en vue d'une connexion ultérieure.

De même l'extrémité opposée au substrat 22 de chaque nanofil 24 est appelée tête des nanofils et comporte un contact dit « de haut » ou de drain 30 d'un transistor tel que décrit précédemment. Tous les contacts de drain 30 ont la même longueur et sont reliés par une couche afin de former une extension pour un unique contact ou électrode de drain pour le dispositif électronique 20, en vue d'une connexion ultérieure.

Les contacts de source 26 sont séparés les uns des autres par une couche d'isolant 32, de même les contacts de drain 30 sont séparés les uns des autres par une autre couche d'isolant 34.

Chaque nanofil 24 est entouré d'une grille formée par une première couche de matériau diélectrique 36 dit « diélectrique de grille » entourant une portion de chaque nanofil et une couche de matériau conducteur 38 dit « conducteur de grille » autour de chaque couche de matériau diélectrique entourant la portion de chaque nanofil.

La couche de matériau diélectrique de grille 36 entourant la portion de chaque nanofil est de préférence en dioxyde de silicium SiO₂ ou un matériau isolant ayant une grande constante diélectrique parmi, par exemple, des oxydes à base d'aluminium (Al), de zirconium (Zr), de Gadolinium (Gd) ou d'hafnium (Hf).

Le matériau conducteur créant l'électrode de grille est de préférence en métal, en siliciure, en silicium ou en polysilicium.

Toutes les secondes couches de conducteur de grille 38 sont reliées entre elles afin de former une unique couche de matériau conducteur « noyant » les nanofils pour former une extension pour un unique contact ou électrode de grille pour le dispositif électronique 20, en vue d'une connexion ultérieure.

L'épaisseur de la couche de matériau conducteur correspond à la longueur de la grille du dispositif de transistors.

De préférence, la longueur de grille du transistor est inférieure à 30 nm.

L'extension du drain est décalée angulairement de préférence de 90° par rapport à l'extension de la grille, elle-même décalée angulairement de 90° par rapport à l'extension de la source afin de minimiser la zone de recouvrement respectivement entre le contact de la grille et le contact du drain et entre le contact de la grille et le contact de la source, et ainsi minimiser les capacités parasites.

Les électrodes de source et de drain sont positionnées de manière symétrique par rapport à l'électrode de grille de chaque transistor implémenté sur un nanofil.

De préférence les couches d'isolants ou diélectriques 32 et 34 sont fabriquées dans le même matériau, par exemple à base d'oxyde de silicium (SiO), de nitrure de silicium (SiN) ou de polymère tels que, par exemple, le polyméthacrylate de méthyle (PMMA), le Polydimethylsiloxane (PDMS), la résine SU-8.

Ces couches diélectriques 32 et 34 sont aptes à isoler chaque électrode de source et de drain pour former les contacts entre la source et la grille et entre le drain et la grille de chaque transistor implémentés sur un nanofil.

L'épaisseur des première et seconde couches de matériau diélectrique 32, 34 et donc la position de la couche de matériau conducteur de grille 38 sont prédéfinies afin que les électrodes de source et de drain soient positionnées de manière symétrique par rapport à l'électrode de grille de chaque transistor implémenté sur un nanofil.

Selon une variante, les électrodes de source et de drain sont positionnées de manière symétrique par rapport à l'électrode de grille par un procédé d'auto-alignement des électrodes de source et de drain sur l'électrode de grille de chaque transistor implémenté autour d'un nanofil.

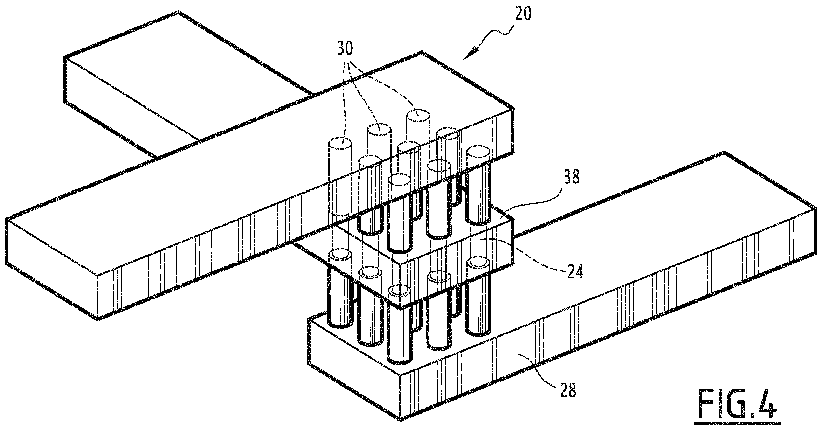

Un tel dispositif 20 de transistors à effet de champ sur un réseau de nanofils verticaux est représenté de façon schématique, de profil sur la figure 4, sur laquelle on reconnait le réseau de nanofils 24, la couche 28 de matériau et la couche 38 de matériau conducteur de grille formant respectivement l'extension/contact de la source et de la grille du dispositif 20.

Les dispositifs de transistors élémentaires (nFET et pFET) fabriqués selon la méthode de fabrication de l'invention peuvent servir à réaliser par exemple des circuits logiques comme des inverseurs CMOS.

Selon d'autres variantes, ces dispositifs électroniques appartiennent au groupe consistant en : un circuit inverseur CMOS, un multiplexeur, une mémoire volatile et une mémoire non volatile, un dispositif pour la détection de gaz ou d'agent biochimique.

Un processeur fabriqué selon la méthode de fabrication de l'invention comporte au moins un dispositif électronique tel que décrit précédemment.

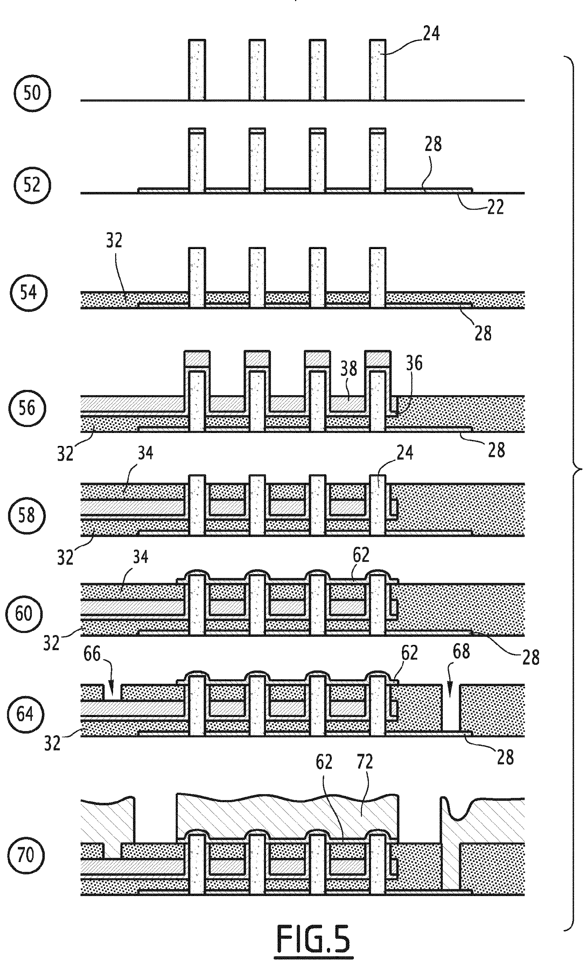

Le procédé de fabrication du dispositif électronique 20 selon l'invention va maintenant être décrit à l'aide de la figure 5.

Le procédé de fabrication débute par la réalisation 50 d'un réseau de nanofils 24.

Les nanofils 24 sont dans un matériau du groupe IV, tel que du silicium (Si), du germanium (Ge)... ou des groupes III-V, par exemple InAs, GaAs ... selon la classification périodique des éléments.

De préférence, les nanofils 24 sont en matériau semi-conducteur de silicium (Si).

En outre, les nanofils sont formés de préférence par approche descendante, par exemple par gravure.

Selon une variante, les nanofils sont formés par approche montante, par exemple par croissance.

En 52, le procédé se poursuit par le dépôt anisotrope d'une couche 28 de matériau de contact source sur le substrat 22. Le métal se trouve alors sur les sommets et aux pieds de chaque nanofils.

Ce matériau est un métal et est choisi en fonction du matériau des nanofils. Par exemple, pour le silicium, on réalise des contacts à faible hauteur de barrière Schottky en utilisant des métaux dits « métaux bord de bande » (Platine Pt pour type p et terre rare Erbium (Er) ou Ytterbium (Yb) pour type n), ou des contacts à base de matériau proche de la moitié du gap du silicium (Ni, Ti, Co, etc.). Une activation thermique permet de faire diffuser le métal dans le fil et de former un siliciure qui permet de réduire la résistance de contact. Si les fils sont à base de III-V on utilise des contacts à base de Palladium/Germanium (Pd/Ge), de Ni, de Titane/Or (Ti/Au) ainsi que des contacts diffusifs par activation thermique.

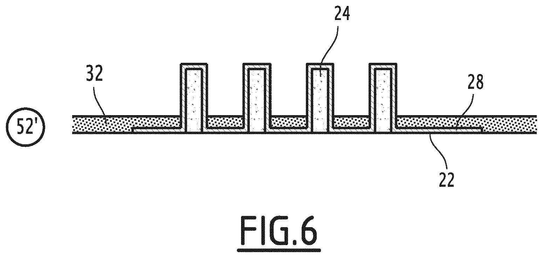

Selon une variante illustrée sur la figure 6, le dépôt est isotrope, étape 52'. Dans ce cas, la même épaisseur de métal est déposée sur les pieds, sur les parois latérales des nanofils et sur le sommet des fils. Un masquage par planarisation permet de graver sélectivement le métal sur les parois du nanofil sans attaquer le métal du pied du nanofil.

Le procédé de fabrication continue, en 54, par une étape de formation d'une première couche d'isolation 32, également appelée étape de planarisation. Après la formation de la couche d'isolation 32, le métal sur le haut des fils est gravé sélectivement.

Cette première couche d'isolation 32 est en matériau diélectrique de préférence de faible constante diélectrique afin de minimiser les capacités de recouvrement.

Par exemple, cette première couche d'isolation 32 est en résine inorganique fluable, tel que l'hydrogensilsesquioxane (HSQ) dont la structure chimique l'apparente à un oxyde de silicium SiOₓ.

Au cours de cette étape 54, la première couche d'isolation 32 est déposée afin de recouvrir tout, c'est-à-dire au moins toute la couche 28 de matériau de contact source et une partie du substrat 22.

Une telle couche d'oxyde de silicium SiOₓ est déposée ou enduite sur le réseau de nanofil par enduction par tournette puis recuit à une température de 100°C afin d'évaporer les solvants présents dans cette couche, permettant de « noyer » totalement le réseau dans la première couche d'isolation 32 et ainsi limiter grandement l'effet de vague.

Selon une variante, ce dépôt est effectué par d'autres techniques de dépôt connues telles que le dépôt chimique en phase vapeur (CVD pour « *chemical vapor déposition* », en anglais) ou le dépôt physique par phase vapeur (PVD pour « *physical vapor deposition* », en anglais). Ensuite, la première couche d'isolation 32 est amincie par une technique telle qu'une gravure chimique ou plasma ou une combinaison de ces deux techniques.

Selon une variante, la première couche d'isolation 32 est amincie par une technique de polissage mécano-chimique jusqu'au niveau supérieur des nanofils puis gravée par voie chimique et/ou plasma.

La fluabilité du matériau constituant la première couche d'isolation 32 est sensiblement comprise entre 0,1 et 3 cSt, c'est-à-dire entre 1.10⁻⁷ et 3.10⁻⁶m²/s, par exemple, elle est égale à 0,6 cSt pour l'hydrogensilsesquioxane (HSQ) permettant lors d'un dépôt par tournette d'obtenir une excellente planéité de la couche, notamment au dessus du réseau de nanofils 24. Le dénivelé ou planéité de la première couche d'isolation 32 est ainsi définie avec une précision sensiblement inférieure ou égale à 5 nanomètres.

Cette excellente planéité couplée avec la gravure contrôlée (plasma et/ou humide) permet de positionner la surface de la première couche d'isolation 32 à une hauteur souhaitée et précise des nanofils 24 la grille 10 autour de chaque nanofil 24.

L'utilisation d'une solution d'acide fluorhydrique extrêmement diluée dans l'eau au 1:1000 permet de contrôler précisément la vitesse de gravure, de préférence sensiblement égale à 1 Angström/s et donc la position/hauteur de la surface de la première couche d'isolation 32 tout en conservant une très faible rugosité de surface identique à la rugosité de la surface de la première couche d'isolation 32 avant gravure, sans effet de vague.

Par exemple, une première couche d'isolation 32 a été réalisée à une hauteur de 110 nm avec une précision sensiblement égale à 1 nm pour un réseau de nanofils de silicium de 25 nm de diamètre et de 220 nm de long.

Le procédé de fabrication se poursuit par le dépôt, en 56, de l'oxyde de grille 36 ou diélectrique de grille, de manière conforme, puis le dépôt d'un conducteur ou métal de grille 38.

Le dépôt de l'oxyde de grille est réalisé par un dépôt de couche atomique (ALD pour « *Atomic Layer Deposition* », en anglais) ou dépôt chimique en phase vapeur (CVD) pour un isolant ayant une haute constante diélectrique, c'est-à-dire supérieure à 5 ou par oxydation thermique pour SiO₂.

Un dépôt physique en phase vapeur permet de déposer anisotropiquement une couche mince de métal 38 sur la surface du diélectrique de grille 36 ainsi obtenue. L'épaisseur de la couche mince de métal de grille 38 est sensiblement inférieure à 30 nm.

En 58, une seconde étape d'isolation ou planarisation est réalisée afin de former la seconde couche d'isolation 34. Cette couche est semblable à l'étape 54 décrite ci-dessus et ne sera donc pas détaillée ici.

Cette seconde étape d'isolation est suivie d'une étape de gravure sélective de l'oxyde de grille 36 et du conducteur de grille 38 situés sur le haut des nanofils 24 afin de dégager la face supérieure des nanofils 24 destinée à former l'électrode ou contact de drain des transistors implémentés sur chaque nanofils 24 du dispositif à transistors.

Le procédé de fabrication se poursuit par le dépôt, en 60, d'une couche 62 formant un contact de drain 62, de préférence la couche 62 est un métal identique à celui constituant la couche 28 formant le contact de source.

Le procédé de fabrication se poursuit de façon conventionnelle par un procédé de formation d'interconnexion dit « back-end » comportant une étape de création, en 64, de trous ou vias 66, 68 respectivement dans la seconde couche isolante 34 et la première couche isolante 32 de diélectrique afin de connecter l'extension/électrode de grille 38 et l'extension/électrode du contact du bas des nanofils 24, c'est-à-dire l'électrode du contact de source 28.

Le procédé « back-end » comporte en outre une étape 70 de dépôt d'un métal 72 dit métal « back end » pour réaliser les contacts entre l'extension de la grille et d'une part l'extension de la source et d'autre part l'extension du drain. L'épaisseur de la couche de métal 72 est sensiblement égale à deux fois celle de la profondeur des trous/vias afin de les remplir et de définir les contacts extrinsèques du drain 62 (haut des nanofils), de la source 28 (bas des nanofils) et de la grille 38.

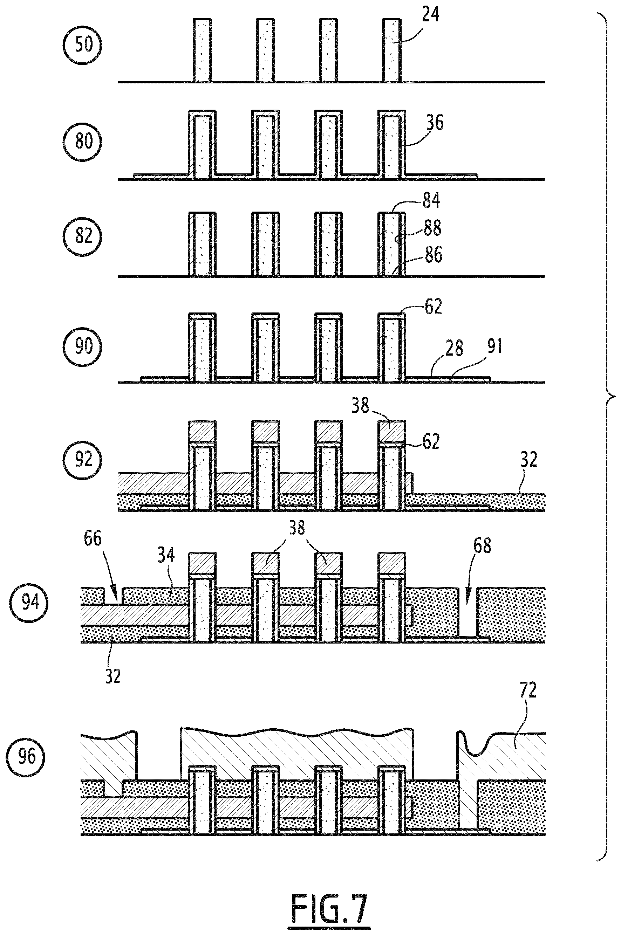

Un second mode de réalisation du procédé de fabrication selon l'invention va maintenant être décrit en regard de la figure 7.

Le procédé de fabrication débute par la même étape de réalisation 50 d'un réseau de nanofils 24.

Il se poursuit par une étape 80 de dépôt de l'oxyde 36 ou diélectrique de grille, de manière conforme. Le dépôt de l'oxyde de grille est réalisé par un dépôt de couche atomique (ALD pour « *Atomic Layer Déposition* », en anglais) ou dépôt chimique en phase vapeur (CVD) pour un isolant ayant une haute constante diélectrique, c'est-à-dire supérieure à 5 ou par oxydation thermique dans le cas d'un diélectrique à base de SiO.

Puis, en 82, une gravure anisotrope du diélectrique de grille 36 est réalisée pour dégager les sommets 84 et les pieds 86 des nanofils 24 tout en conservant le diélectrique de grille 36 sur les parois latérales 88 des nanofils.

Le procédé de fabrication se poursuit par un dépôt 90 d'une couche de matériau de contact de source 28 et de contact de drain 62, de préférence le matériau appelé matériau de contact source/drain est un métal. Il est déposé de manière anisotrope, par exemple par dépôt physique par phase vapeur (PVD), afin de recouvrir le sommet 84 et les pieds 86 des nanofils 24 tout en formant une extension 91 pour recevoir la connexion vers le contact de source 28. Suivant le métal et le matériau du nanofil choisis, une activation thermique comme décrite précédemment peut être réalisée.

En 92, une étape d'isolation entre la source et la grille est réalisée par le dépôt d'une première couche d'isolation 32, également appelée étape de planarisation. Une telle étape a déjà été décrite précédemment et ne sera donc pas détaillée ici.

Cette étape d'isolation et de planarisation est destinée à positionner la surface supérieure de la première couche d'isolation 32 et ainsi la couche de conducteur de grille à hauteur souhaitée, comme explicité dans le mode de réalisation précédent.

L'étape d'isolation et de planarisation est suivie d'une étape de dépôt du conducteur de grille 38, de préférence un métal, par exemple du chrome (Cr), du nitrure de titane (TiN), de nitrure de tantale (TaN), de tungstene (W)... afin de former la grille enrobant les nanofils 24. Le dépôt est réalisé de façon anisotrope. L'épaisseur de métal déposée correspondant à la longueur de grille Lg du transistor.

Selon une variante, le métal est déposé de façon anisotrope suivie d'une étape de planarisation et de gravure sélective comme décrit précédemment.

Ainsi, des longueurs de grille de dimension nanométriques sont réalisées sans avoir recours à une technique de lithographie ultime.

Le dépôt métallique permet également de former une extension de la couche formant la grille du dispositif de transistors, destinée à recevoir une connexion vers l'accès de contact de grille. Cette extension est décalée angulairement de 90° par rapport à l'extension de la source afin de minimiser la zone de recouvrement entre le contact de la grille et le contact de la source et par conséquent les capacités parasites.

Cette zone de recouvrement étant limitée à la partie active du transistor, une plus grande densité de nanofils permet de diminuer la surface de la zone de recouvrement.

Le procédé de fabrication se poursuit par une seconde étape d'isolation/de planarisation afin de former une seconde couche d'isolation 34. Cette étape de planarisation est similaire à l'étape 58 du mode de réalisation précédent et ne sera donc pas détaillée ici.

Cette étape de planarisation est suivie d'une étape de gravure sélective du métal de grille 38 situé sur le haut des nanofils 24 afin d'ouvrir le contact du haut des nanofils 24, destiné à être le contact de drain, encore décalé de 90° avec le précédent.

Le procédé de fabrication se poursuit de façon conventionnelle par un procédé dit « back-end » comportant une étape de création, en 94, de trous ou vias 66, 68 respectivement dans la seconde couche isolante 34 et la première couche isolante 32 de diélectrique afin de connecter l'extension/électrode de grille 38 et l'extension/électrode du contact du bas des nanofils 24, c'est-à-dire l'électrode du contact de source 28.

Le procédé « back-end » comporte en outre une étape 96 de dépôt d'un métal 72 dit métal « back end » pour réaliser les contacts entre l'extension de la grille et d'une part l'extension de la source et d'autre part l'extension du drain. L'épaisseur de la couche de métal 72 est sensiblement égale à deux fois celle de la profondeur des trous/vias afin de les remplir et de définir les contacts extrinsèques du drain 62 (haut des nanofils), de la source 28 (bas des nanofils) et de la grille 38.

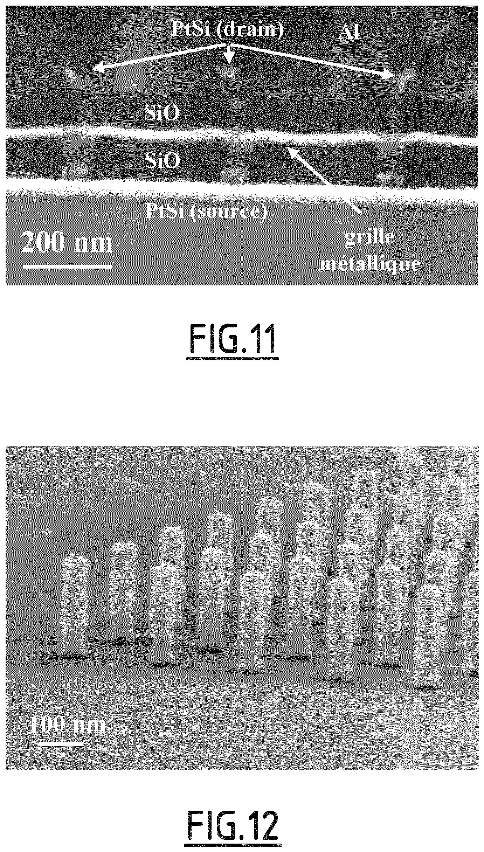

La figure 11 est une vue en coupe réalisée par microscopie STEM (pour *« Scanning transmission electron microscopy »,* en anglais) d'un dispositif FET vertical sur un réseau de nanofils de silicium avec une grille enrobante ultra courte (15 nm) et des zones source/drain siliciurées en PtSi.

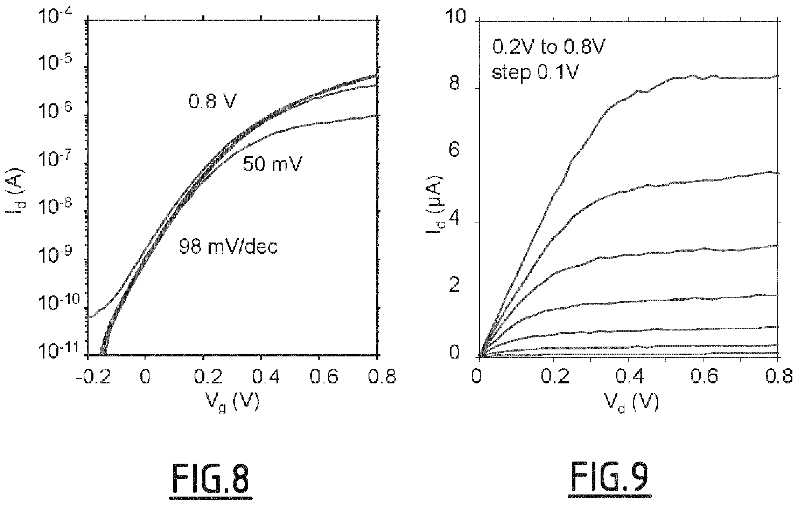

Les figures 8 et 9 illustrent une caractérisation statique obtenue pour un dispositif de transistors à effet de champ implémentés sur un réseau de nanofils verticaux, ici un pFET de 15 nm de longueur de grille sur un réseau de 81 fils de 18 nm de diamètre chacun tel qu'observé en figure 11. En outre, l'oxyde de grille de ce dispositif de transistors pFET est SiO₂ (κ=3,9).

En regard de la figure 8, le fonctionnement du dispositif de transistors est excellent en considérant son dimensionnement extrême. Le contrôle des effets canaux courts est très bon avec une pente sous le seuil de 98 mV/décade, un abaissement de la barrière de potentiel sous la grille causé par l'augmentation de la tension de drain (DIBL pour « *Drain Induced Barrier Lowering* », en anglais) de 8 mV et un ratio Iₒₙ/I_{off} proche de 5 décades. La tension de polarisation, V_{DD}=0,8V, est cohérent avec la technologie.

Il faut noter que les nanofils ne sont pas intrinsèquement dopés (comme dans des technologies en couches minces classiques) mais d'un niveau uniforme assez élevé (∼8.10¹⁸ atomes/cm pour le dispositif de transistor pFET caractérisé).

Le contrôle électrostatique du canal n'est pas affecté lorsque des diamètres de nanofils suffisamment petits sont réalisés, par exemple des diamètres sensiblement égaux à 30 nm. Dans ce cas, le diamètre des fils est diminué proportionnellement avec la longueur des grilles. La perte de contrôle du canal se traduit par une nette dégradation de la pente sous le seuil et une augmentation du courant à l'état off. Ce phénomène est visible pour des diamètres supérieurs à 30 nm.

En outre, le dopage uniforme élevé offre l'avantage d'une faible résistance d'accès à la fois au niveau du contact métal/semi-conducteur (contact ohmique) qu'au niveau de la résistance du fil jusqu'à la grille (résistance d'espaceur en technologie conventionnelle).

En outre, le procédé de fabrication s'en trouve simplifié. En effet, il n'y a pas de structure grille auto-alignée et pas de dopage spécifique des zones source/drain.

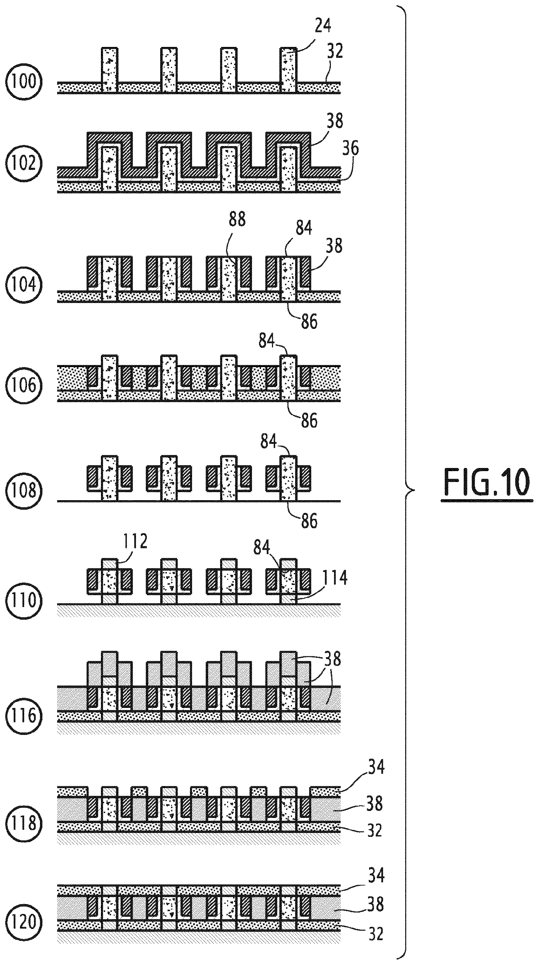

Un exemple ne faisant pas partie de l'invention telle que revendiquée est décrit en regard de la figure 10, afin de fabriquer un dispositif de transistors FET implémentés sur un réseau de nanofils verticaux dans lequel les zones de source et de drain sont alignées avec une grille nanométrique entourant chaque nanofil. En effet, en masquant une zone commune à tous les fils pour ne découvrir que le bas des nanofils ou le bas et le haut des nanofils, on réalise une zone dopée ou métallique auto-alignée sur la zone masquée, c'est-à-dire la grille.

Le procédé de fabrication débute par une étape (non représentée) de formation du réseau de nanofils verticaux 24 tels que décrit ci-avant.

Le procédé se poursuit par un dépôt 100 d'une couche 32 d'isolant/diélectrique et une étape de planarisation à un tiers de la hauteur des nanofils.

En 102, l'empilement de grille est constitué d'un diélectrique, par exemple une couche d'isolant (36) de haute constante diélectrique κ et une fine couche de métal de grille ou de poly-silicium. Ces deux dépôts sont réalisés de manière conforme par ALD ou CVD.

En 104, une étape de gravure anisotrope de cet empilement de grille 38, 36 permet de retirer l'épaisseur de matériau présent sur la couche d'isolant 32 sans attaquer la couche recouvrant les parois latérales des nanofils 24. A ce stade, la gravure sélective de la couche d'isolant 32 permet d'obtenir un masquage de la partie supérieure des nanofils du réseau tel qu'observé dans la figure 12. Celle-ci est une image obtenue par microscopie électronique à balayage d'un réseau de nanofils en Si avec un empilement de grille, c'est-à-dire un isolant de haute constante diélectrique κ et une couche conductrice en poly-silicium, qui enrobe la partie supérieure des nanofils laissant leurs bases libres, après gravure de l'isolant de planarisation.

En 106, une seconde étape de dépôt d'un isolant et de planarisation est réalisée. Cette étape 106 permet de définir la longueur de la grille par l'épaisseur de la seconde couche d'isolant.

Puis une étape de gravure isotrope des couches 36, 38 est réalisée afin « de retirer » les couches de matériau 36, 38 qui recouvrent la partie supérieure de chaque nanofil sans graver la partie protégée par la deuxième planarisation.

En 108, la gravure sélective de l'isolant/diélectrique de planarisation permet de libérer l'accès du pied, par exemple la source, des nanofils, réalisant ainsi l'empilement de grille nanométrique localisé au milieu de la hauteur des nanofils et permettant ainsi la définition de zones source/drain auto-alignées sur cette structure.

Le procédé de fabrication se poursuit en 110 par une étape de définition des zones source/drain auto-alignées sur grille. En effet, lors de la formation des sources/drains, la grille sert de masquage pour que ces deux zones sources/drains soient parfaitement alignées.

En 110, une étape de dopage de la source 114 et du drain 112 auto-alignés conforme est réalisée par exemple par plasma ou résine fluable dopée. Ainsi, la source 114 et le drain 112 sont parfaitement autoalignés sur la grille déjà définie.

Selon une variante, l'étape 110 est une étape de métallisation diffusive sélective source/drain. Cette étape comprend un dépôt de métal isotrope par CVD ou ALD, puis une activation thermique, permettant de faire réagir le métal en contact avec le semi-conducteur. Une gravure sélective du métal non réagit permet l'obtention de la source ou du drain métallique parfaitement aligné sur la grille. Pour des nanofils en matériau du groupe IV, cette étape est appelé siliciuration (Si) ou germiniuration (Ge) mais peut aussi être développée en filière III-V.

En outre, cette étape de siliciuration peut être combinée avec l'étape de dopage décrite.

Le procédé de fabrication se poursuit, en 116 par une planarisation de l'isolant jusqu'au niveau bas de la grille puis par un dépôt d'un conducteur de grille, de préférence un métal, pour connecter toutes les grilles (préformées) entre elles. Ce métal est identique au métal de grille.

Selon une variante, ce métal est différent du métal de grille.

En 118, une autre étape de dépôt d'une couche d'isolant suivi d'une planarisation et d'une gravure sélective du conducteur de grille, se trouvant sur le haut du fil et sur la grille, est réalisée.

Ensuite en 120, une dernière étape de planarisation est réalisée pour isoler la grille du drain et ainsi dégager le haut des fils pour l'étape de back-end.

Le procédé se termine de façon connue par un procédé « back-end » tel que décrit précédemment.

Le procédé de fabrication selon l'invention permet de fabriquer des dispositifs de transistors FET implémentés sur un réseau de nanofils verticaux ayant une grille conductrice, enrobant chaque nanofil, de dimension nanométrique et permettant ainsi de contrôler le passage du courant dans des canaux.

En outre, il permet de fabriquer des transistors dont la source et le drain sont symétriques par rapport à la grille. En effet, selon les deux premiers modes de réalisation, la symétrie est par la précision de l'amincissement/planarisation des couches d'isolation par gravure, les deux couches d'isolant devant avoir la même épaisseur. Dans le procédé de la figure 10, la grille est formée en premier puis les zones source et drain sont parfaitement auto-alignées sur la grille.

En outre, pour des applications hyperfréquences, il essentiel de minimiser les capacités parasites de recouvrement grille/source et grille/drain ce qui est obtenu par le procédé de fabrication selon l'invention.

Le dispositif de transistors obtenu grâce au procédé de l'invention permet de moduler plusieurs leviers :
- la diminution de la surface de recouvrement qui est liée à la possibilité d'implémenter des réseaux très denses,
- l'utilisation de matière à faible constante diélectrique, par exemple un oxyde de basse densité de constante diélectrique proche de 2,7 et
- l'augmentation de la distance entre la grille et les contacts de haut et de bas (source/drain).

De façon avantageuse, le procédé de fabrication selon l'invention n'utilise que de techniques/technologies existantes dans la microélectronique. De plus, il permet d'apporter une solution crédible à la fabrication de nano-dispositifs à effet de champs dont les dimensions sont très réduites sans toutefois recourir à des développements de machines nouvelles ou à couts élevés, comme l'utilisation de lithographie ultime.

Ainsi, le procédé de fabrication permettant de réaliser des grilles de dimensions nanométriques est aisément transposable à des dimensions plus grandes (microns) pour des applications de détections.

De plus, le procédé est compatible et flexible avec les différentes routes de recherche et développement suivis actuellement telles que l'intégration sur différents matériaux de nanofils, l'intégration tridimensionnelle, l'électronique sur substrat souple...

En outre, le procédé de fabrication permet d'optimiser les contacts de bas et de haut, dits source/drain, proposant ainsi une faible résistance d'accès ainsi que de faibles capacités de recouvrement.

De façon avantageuse, ces différents modes de réalisation du procédé de fabrication selon l'invention sont compatibles avec la fabrication de circuits logiques élémentaires tels par exemple des inverseurs CMOS.

En effet, pour réaliser une version purement silicium, il suffit de définir deux caissons (type n et type p) de dopage uniforme par exemple de l'ordre de 10¹⁹ impuretés/cm² et ensuite de réaliser deux réseaux de nanofils par voie descendante. Les deux dispositifs (nFET et pFET) sont alors réalisés en parallèle en suivant le procédé selon l'invention décrit précédemment puis simplement interconnectés par une technologie via et métallisation conventionnelle.

Ce procédé de fabrication peut être utilisé avec des réseaux de nanofils de matériaux différents puisque le procédé est générique. Par exemple, on peut réaliser des réseaux de nanofils III-V pour le type n associés à des nanofils en Ge ou Si pour le type p ou même réaliser le nFET et le pFET sur des réseaux III-V.

## Revendications

1. Procédé de fabrication d'un dispositif (20) de transistor à effet de champ implémenté sur un réseau de nanofils verticaux (24) comportant une pluralité de transistors élémentaires, chaque transistor élémentaire comprenant une électrode de source et une électrode de drain disposées chacune à une extrémité d'un nanofil vertical du réseau et reliées par un canal et chaque transistor élémentaire comportant une électrode de grille entourant chaque nanofil vertical du réseau, les électrodes de drain, de source et de grille des transistors élémentaires implémentés sur les nanofils sont respectivement reliées entre elles de sorte à former d'uniques électrodes de drain, de source et de grille du dispositif de transistor,
ledit procédé étant **caractérisé en ce qu'**il comprend les étapes suivantes :
- réalisation d'un réseau de nanofils verticaux (24) ;
- création des électrodes de source (26) et de drain (30) à chaque extrémité de chaque nanofil vertical (24) préalablement formé, les électrodes de source et de drain étant positionnées de manière symétrique par rapport à l'électrode de grille de chaque transistor élémentaire implémenté sur un nanofil ;
- création d'une électrode de grille par dépôt d'une couche de matériau diélectrique (36) entourant une portion de chaque nanofil (24) préalablement formé et dépôt d'une couche de matériau conducteur (38) autour de chaque couche de matériau diélectrique (36) entourant la portion de chaque nanofil (24) préalablement formé, la couche de matériau conducteur (38) étant unique pour tous les nanofils préalablement formés du réseau et l'épaisseur de la couche de matériau conducteur correspondant à la longueur de la grille du dispositif de transistors ; et
- isolation de chaque électrode par une couche plane d'un matériau diélectrique (32, 34) afin de former une grille nanométrique et d'isoler les contacts entre la source et la grille et entre le drain et la grille de chaque transistor élémentaire implémenté sur un nanofil préalablement formé.

2. Procédé de fabrication selon la revendication 1, **caractérisé en ce que** les électrodes de source et de drain sont positionnées de manière symétrique par rapport à l'électrode de grille par un procédé d'auto-alignement des électrodes de source et de drain sur l'électrode de grille de chaque transistor implémenté autour d'un nanofil.

3. Procédé de fabrication selon la revendication 1, **caractérisé en ce que** l'étape d'isolation de chaque électrode de source et de drain par un diélectrique est réalisée par un dépôt d'une première couche de matériau diélectrique (32) et d'une seconde couche de matériau diélectrique (34), la couche de matériau conducteur (38) créant l'électrode de grille étant déposée au dessus de la première couche de matériau diélectrique et la seconde couche de matériau diélectrique étant déposée au dessus de la couche de matériau conducteur créant l'électrode de grille, l'épaisseur des première et seconde couches de matériau diélectrique et la position de la couche de matériau conducteur créant l'électrode de grille étant prédéfinies afin que les électrodes de source et de drain sont positionnées de manière symétrique par rapport à l'électrode de grille de chaque transistor implémenté sur un nanofil.

4. Procédé de fabrication selon la revendication 3, **caractérisé en ce que** la planéité de la première couche de matériau diélectrique est définie avec une précision sensiblement inférieure ou égale à 5 nanomètres.

5. Procédé de fabrication selon l'une quelconque des revendications 3 et 4, **caractérisé en ce que** le matériau diélectrique des première et seconde couches de matériau diélectrique (32, 34) est une résine inorganique fluable.

6. Procédé de fabrication selon l'une quelconque des revendications 1 à 5, **caractérisé en ce que** l'épaisseur de la couche de matériau conducteur créant l'électrode de grille est inférieure à 20 nm, l'épaisseur de la couche définissant la longueur de la grille.

## Patentansprüche

1. Verfahren zum Herstellen einer
Feldeffekttransistorvorrichtung (20), die in einem Netz aus vertikalen Nanodrähten (24) implementiert ist, aufweisend eine Mehrzahl von Elementartransistoren, wobei jeder Elementartransistor eine Source-Elektrode und eine Drain-Elektrode aufweist, die jeweils an einem Ende eines vertikalen Nanodrahtes des Netzes angeordnet sind und durch einen Kanal verbunden sind, und wobei jeder Elementartransistor eine Gate-Elektrode aufweist, die jeden vertikalen Nanodraht des Netzes umgibt, wobei die Drain-, die Source- und die Gate-Elektroden der auf den Nanodrähten implementierten Elementartransistoren jeweils miteinander verbunden sind, um einzige Drain- Source- und Gate-Elektroden der Transistorvorrichtung auszubilden,
wobei das Verfahren **dadurch gekennzeichnet ist, dass** es die folgenden Schritte aufweist:
- Realisieren eines Netzes aus vertikalen Nanodrähten (24),
- Erzeugen der Source- (26) und Drain- (30) Elektroden an jedem Ende jedes zuvor gebildeten vertikalen Nanodrahtes (24), wobei die Source- und die Drain-Elektroden bezüglich der Gate-Elektrode jedes auf einem Nanodraht implementierten Elementartransistors auf symmetrische Weise positioniert werden,
- Erzeugen einer Gate-Elektrode durch Abscheiden einer Schicht aus einem dielektrischen Material (36), die einen Abschnitt jedes zuvor gebildeten Nanodrahtes (24) umgibt, und durch Abscheiden einer Schicht aus einem leitfähigen Material (38) um jede Schicht aus dielektrischem Material (36), die den Abschnitt jedes zuvor gebildeten Nanodrahtes (24) umgibt, wobei die Schicht aus leitfähigem Material (38) für alle zuvor gebildeten Nanodrähte des Netzes einzig ist und die Dicke der Schicht aus leitfähigem Material der Länge des Gates der Transistorvorrichtung entspricht, und
- Isolieren jeder Elektrode durch eine planare Schicht aus einem dielektrischen Material (32, 34), um ein Gate im Nanometerbereich zu bilden und die Kontakte zwischen Source und Gate und zwischen Drain und Gate von jedem Elementartransistor zu isolieren, der auf einem zuvor gebildeten Nanodraht implementiert ist.

2. Verfahren zum Herstellen gemäß Anspruch 1, **dadurch gekennzeichnet, dass** die Source- und Drain-Elektroden bezüglich der Gate-Elektrode mittels eines Verfahrens des Selbstausrichtens der Source- und Drain-Elektroden auf der Gate-Elektrode jedes Transistors, der um einen Nanodraht herum implementiert ist, auf symmetrische Weise positioniert werden.

3. Verfahren zum Herstellen gemäß Anspruch 1, **dadurch gekennzeichnet, dass** der Schritt des Isolierens jeder Source- und Drain-Elektrode durch ein Dielektrikum durch ein Abscheiden einer ersten Schicht aus einem dielektrischen Material (32) und einer zweiten Schicht aus einem dielektrischen Material (34) realisiert wird, wobei die Schicht aus leitfähigem Material (38), die die Gate-Elektrode erzeugt, über der ersten Schicht aus dielektrischem Material abgeschieden wird, und die zweite Schicht aus dielektrischem Material über der Schicht aus leitfähigem Material abgeschieden wird, die die Gate-Elektrode erzeugt, wobei die Dicke der ersten und der zweiten Schicht aus dielektrischem Material und die Position der Schicht aus leitfähigem Material, die die Gate-Elektrode erzeugt, vordefiniert werden, damit die Source- und Drain-Elektroden bezüglich der Gate-Elektrode jedes auf einem Nanodraht implementierten Transistors auf symmetrische Weise angeordnet werden.

4. Verfahren zum Herstellen gemäß Anspruch 3, **dadurch gekennzeichnet, dass** die Ebenheit der ersten Schicht aus dielektrischem Material mit einer Präzision definiert wird, die im Wesentlichen kleiner oder gleich 5 Nanometer ist.

5. Verfahren zum Herstellen gemäß irgendeinem der Ansprüche 3 und 4, **dadurch gekennzeichnet, dass** das dielektrische Material der ersten und der zweiten Schicht aus dielektrischem Material (32, 34) ein fließfähiges anorganisches Harz ist.

6. Verfahren zum Herstellen gemäß irgendeinem der Ansprüche 1 bis 5, **dadurch gekennzeichnet, dass** die Dicke der Schicht aus leitfähigem Material, die die Gate-Elektrode erzeugt, kleiner als 20 nm ist, wobei die Dicke der Schicht die Länge des Gates definiert.

## Claims

1. A fabrication method for fabricating a field-effect transistor device (20) implemented on a network of vertical nanowires (24), including a plurality of elementary transistors, each elementary transistor comprising a source electrode and a drain electrode each positioned at one end of a vertical nanowire of the network and connected by a channel and each elementary transistor including a gate electrode surrounding each vertical nanowire of the network, the drain, source and gate electrodes of the elementary transistors implemented on the nanowires are respectively connected to each other so as to form unique drain, source and gate electrodes of the transistor device,
said method being **characterized in that** it comprises the following steps:
- forming a network of vertical nanowires (24);
- producing source (26) and drain (30) electrodes at each end of each previously-formed vertical nanowire (24), the source and drain electrodes being positioned symmetrically with respect to the gate electrode of each elementary transistor implemented on a nanowire;
- creating a gate electrode by depositing a layer of dielectric material (36) surrounding a portion of each previously-formed nanowire (24) and depositing a layer of conductive material (38) around each layer of dielectric material (36) surrounding the portion of each previously-formed nanowire (24), the layer of conductive material (38) being unique for all of the previously-formed nanowires of the network and the thickness of the layer of conductive material corresponding to the length of the gate of the transistor device; and
- insulating each electrode using a planar layer of a dielectric material (32, 34) so as to form a nanoscale gate and insulate the contacts between the source and the gate and between the drain and the gate of each elementary transistor implemented on a previously-formed nanowire.

2. The fabrication method according to claim 1, **characterized in that** the source and drain electrodes are positioned symmetrically with respect to the gate electrode using an auto-alignment method of the source and drain electrodes on the gate electrode of each transistor implemented around a nanowire.

3. The fabrication method according to claim 1, **characterized in that** the step for insulating each source and drain electrode using the dielectric is done by depositing a first layer of dielectric material (32) and a second layer of dielectric material (34), the layer of conductive material (38) creating the gate electrode being deposited above the first layer of dielectric material and the second layer of dielectric material being deposited above the layer of conductive material creating the gate electrode, the thickness of the first and second layers of dielectric material and the position of the layer of conductive material creating the gate electrode being predefined so that the source and drain electrodes are positioned symmetrically with respect to the gate electrode of each transistor implemented on a nanowire.

4. The fabrication method according to claim 3, **characterized in that** the flatness of the first layer of dielectric material is defined with a precision substantially less than or equal to 5 nm.

5. The fabrication method according to any one of claims 3 and 4, **characterized in that** the dielectric material of the first and second layers of dielectric material (32, 34) is a fluent inorganic resin.

6. The fabrication method according to any one of claims 1 to 5, **characterized in that** the thickness of the layer of conductive material creating the gate electrode is smaller than 20 nm, the thickness of the layer defining the length of the gate.
